# EUROPÄISCHE PATENTSCHRIFT

(11) **EP 3 832 324 B1**
(45) Veröffentlichungstag und Bekanntmachung des Hinweises auf die Patenterteilung: **13.03.2024**
(21) Anmeldenummer: 20208363.0
(22) Anmeldetag: 18.11.2020
(51) Int. Cl.: G01R 27/18, G01R 31/52

(54) **SCHALTUNGSANORDNUNG MIT AKTIVER MESSSPANNUNG ZUR BESTIMMUNG EINES ISOLATIONSWIDERSTANDS GEGEN ERDPOTENTIAL IN EINEM UNGEERDETEN STROMVERSORGUNGSSYSTEM**
CIRCUIT ASSEMBLY WITH ACTIVE MEASURING VOLTAGE FOR DETERMINING AN INSULATION RESISTANCE TO GROUND POTENTIAL IN AN UNEARTHED POWER SUPPLY SYSTEM
AGENCEMENT DE CIRCUIT À TENSION DE MESURE ACTIVE PERMETTANT DE DÉTERMINER LA RÉSISTANCE D'ISOLATION PAR RAPPORT À LA TERRE DANS UN SYSTÈME D'ALIMENTATION EN COURANT NON MIS À LA TERRE

(30) Priorität: 28.11.2019 DE 102019132242
(43) Veröffentlichungstag der Anmeldung: 09.06.2021
(73) Patentinhaber: Bender GmbH & Co. KG, 35305 Grünberg (DE)
(72) Erfinder: SCHÄFER, Oliver, 35305 Grünberg (DE); MACHT, Burkhard, 35410 Hungen (DE)
(74) Vertreter: advotec.

(56) Entgegenhaltungen:
- DE-A1- 3 346 387
- DE-A1-102011 050 590
- DE-A1-102012 019 094

## Beschreibung

Die Erfindung betrifft die Verwendung einer Schaltungsanordnung mit einer aktiven Messspannung zur Bestimmung eines Isolationswiderstandes oder einer komplexwertigen Isolationsimpedanz gemäß einem der Ansprüche 1-4.

Bei erhöhten Anforderungen an die Betriebs-, Brand und Berührungssicherheit kommt die Netzform eines ungeerdeten Stromversorgungssystems zum Einsatz, die auch als isoliertes Netz oder als IT-Stromversorgungssystem (frz. Isolé Terre - IT) bezeichnet wird. Bei dieser Art des Stromversorgungssystems sind dessen aktiven Teile von dem Erdpotenzial - gegenüber "Erde" - getrennt. Der Vorteil dieser Netze liegt darin, dass bei einem Isolationsfehler (erster Fehler), wie beispielsweise einem Erdschluss eines aktiven Leiters des Stromversorgungssystems, die Funktion der angeschlossenen elektrischen Verbraucher nicht beeinträchtigt wird, da sich wegen des im Idealfall unendlich großen Impedanzwertes zwischen dem aktiven Leiter des Netzes und Erde kein geschlossener Stromkreis ausbilden kann. Netzableitkapazitäten - die in Parallelschaltung mit einem Isolationswiderstand eine komplexwertige Isolationsimpedanz des Stromversorgungssystems bilden - seien bei dieser Betrachtung vernachlässigt. Das im Rahmen der Erfindung betrachtete ungeerdete Stromversorgungssystem kann ein Wechselstrom- oder ein Gleichstromsystem oder eine Mischform beider Systeme sein.

Der elektrische Widerstand des ungeerdeten Stromversorgungssystems gegen das Erdpotenzial (Isolationswiderstand - im Fehlerfall auch Isolationsfehlerwiderstand oder Fehlerwiderstand) muss daher vorschriftsmäßig mit einem normgerechten Isolationsüberwachungsgerät (Insulation Monitoring Device - IMD) überwacht werden, da durch einen möglichen weiteren Fehler an einem anderen aktiven Leiter (zweiter Fehler) eine Fehlerschleife entstünde und der dabei fließende Fehlerstrom in Verbindung mit einer Überstrom-Schutzeinrichtung eine Abschaltung der Anlage mit Betriebsstillstand zur Folge hätte.

Neben passiven Isolationsüberwachungsgeräten, die eine Netzspannung des Stromversorgungssystems als treibende Quelle für einen Messstrom nutzen, um einen Isolationsfehler zu detektieren, sind aus dem Stand der Technik aktive Isolationsüberwachungsgeräte bekannt. Diese weisen einen zwischen einem oder mehreren aktiven Leiter(n) des Stromversorgungssystems und dem Erdpotenzial verlaufenden Messpfad auf, der einen internen Messspannungsgenerator umfasst. Eine von dem Messspannungsgenerator erzeugte Messspannung treibt aktiv einen Messstrom über den/die aktiven Leiter und über den Isolationswiderstand zurück in den Messpfad, der einen in Reihe zu dem Messspannungsgenerator geschalteten Messwiderstand zum Abgriff einer gemessenen Spannung und einen in Reihe geschalteten Ankoppelwiderstand zur Ankopplung an das Stromversorgungssystem aufweist. Der über dem Messwiderstand abgenommene Spannungsabfall wird zur Auswertung über einen Signaleingang einer Signalauswerteschaltung zur Bestimmung des Isolationswiderstandes zugeführt.

Im einfachsten Fall reicht dabei eine einpolige Ankoppelung mit genau einem Messpfad an nur einen aktiven Leiter aus. In mehrpoligen ungeerdeten Stromversorgungssystemen kann eine Ankoppelung mit mindestens zwei Messpfaden sinnvoll sein, um auch eine Netz- und Verlagerungsspannung messen sowie eine Ankopplungsüberwachung realisieren zu können.

In ungeerdeten Stromversorgungssystemen, deren Konfiguration veränderbar ist, wie beispielsweise bei gekoppelten ungeerdeten Stromversorgungssystemen auf Schiffen, wo je nach Lastfall Generatoren zu- oder abgeschaltet werden, die unterschiedliche IT-Netze versorgen, müssen auch die Isolationsüberwachungsgeräte miteinander gekoppelt werden. Als Nachteil erweist sich dabei, dass diese Kopplung der Isolationsüberwachungsgeräte über eine galvanisch trennbare Strecke ausgeführt wird, da die Schnittstellen zwischen den Isolationsüberwachungsgeräten keinen direkten Erdbezug haben und es somit zu Signalverschleifungen kommen kann.

Bei den bislang bekannten Isolationsüberwachungsgeräten ist die Reihenschaltung des Messpfades so aufgebaut, dass der Masseanschluss der Signalauswerteschaltung nicht mit Erdpotenzial verbunden ist. Sämtliche Schnittstellensignale der Isolationsüberwachungsgeräte sind daher mit der (Gleichtakt-) Messspannung gegen Erde überlagert und müssen bei der Einbindung in das ungeerdete Stromversorgungssystem galvanisch getrennt übertragen werden. Es darf also keine galvanische Verbindung zwischen den Isolationsüberwachungsgeräten und zu anderen geerdeten Geräten bestehen. Diese galvanisch getrennten Schnittstellen stellen aber einen erheblichen Kostenfaktor da, zumal sie in jedem Isolationsüberwachungsgerät implementiert werden müssen. So sind beispielsweise zur Weiterleitung von Alarmmeldungen Relais oder für digitale Schnittstellen Datenkoppler erforderlich, um eine galvanische Trennung zu bewirken. Relevanter Stand der Technik findet sich in den Dokumenten DE102012019094A1, DE3346387A1 und DE102011050590A1.

Der vorliegenden Erfindung liegt somit die Aufgabe zu Grunde, eine Schaltungsanordnung mit aktiver Messspannung zur Bestimmung des Isolationswiderstands oder zur Bestimmung der komplexwertigen Isolationsimpedanz sowie deren Verwendungsmöglichkeiten für ein ungeerdetes Stromversorgungssystem zu beschreiben, wobei eine aufwendige galvanische Trennung zwischen Isolationsüberwachungsgeräten bei deren Kopplung entbehrlich ist.

Diese Aufgabe wird durch die Verwendung einer Schaltungsanordnung mit einer aktiven Messspannung zur Bestimmung eines Isolationswiderstandes oder einer komplexwertigen Isolationsimpedanz gemäß einem der Ansprüche 1-4 gelöst.

Der Grundgedanke der vorliegenden Erfindung beruht somit darauf, den Masseanschluss der Signalauswerteschaltung auf Erdpotenzial zu legen. Aufgrund eines so nicht vorhandenen Potentialgefälles können Störströme (Signalverschleifungen) verhindert werden. Für sämtliche analogen und digitalen Schnittstellen bedarf es keiner galvanischen Trennung mehr. Durch diesen Verzicht der galvanischen Trennung aller Schnittstellen der Signalauswerteschaltung einschließlich ihrer Spannungsversorgung gegenüber Erde können Isolationsüberwachungsgeräte gekoppelt werden, ohne dass es zu Messverfälschungen durch störende Schleifenströme kommt.

Der Messpfad ist so ausgestattet, dass in einer ersten Reihenfolge das Erdpotenzial, der Messspannungsgenerator, der Messwiderstand und der Ankoppelwiderstand eine Reihenschaltung bilden.

Die Elemente des Messpfades, also die Messpfadelemente Messspannungsgenerator, Messwiderstand und Ankoppelwiderstand, sind ausgehend von dem Erdpotenzial in einer ersten Reihenfolge beginnend mit dem Messspannungsgenerator, darauffolgend der Messwiderstand und daran anschließend der Ankoppelwiderstand angeordnet.

In dieser ersten Messanordnung befindet sich ein Anschluss des Messspannungsgenerators gemeinsam mit dem Masseanschluss der Signalauswerteschaltung auf Erdpotenzial.

Dabei wird die nur wenige Volt große (Größenordnung ± 2 Volt) über dem Messwiderstand gemessene Spannung von der größeren (Gleichtakt-) Messspannung (Größenordnung ±20 Volt) überlagert, sodass die Signalauswerteschaltung für die gemessenen Spannungen mit hoher Gleichtaktunterdrückung arbeiten muss.

Weiterhin ist eine mehrpolige Ankopplung in einem ungeerdeten Stromversorgungssystem mit mindestens zwei Leitern vorgesehen, wobei mindestens zwei der aktiven Leiter jeweils über einen Messpfad mit dem Erdpotenzial verbunden sind.

In einem ungeerdeten Stromversorgungssystem mit mehreren aktiven Leitern erweist es sich somit vorteilhaft, für mindestens zwei aktive Leiter jeweils einen Messpfad zu installieren.

Die Messpfade können dabei vollständig separat, also mit jeweils einem eigenen Messspannungsgenerator, einem Messwiderstand und einem Ankoppelwiderstand ausgeführt werden, oder mindestens zwei Messpfade können einen gemeinsamen Messspannungsgenerator aufweisen.

Alternativ zu der ersten Reihenfolge ist der Messpfad in einer zweiten Reihenfolge derart ausgeführt, dass ausgehend von dem Erdpotenzial der Messwiderstand, der Messspannungsgenerator und der Ankoppelwiderstand eine Reihenschaltung ausbilden.

In dieser zweiten Messanordnung befindet sich ein Anschluss des Messwiderstands gemeinsam mit dem Masseanschluss der Signalauswerteschaltung auf Erdpotenzial.

Hier erfolgt eine Abnahme der gemessenen Spannung über dem Messwiderstand direkt gegen Erdpotenzial, die Erfassung der (Gleichtakt-) Messspannung erfolgt hingegen differenziell. In diesem Fall muss an die Gleichtaktunterdrückung keine hohe Anforderung gestellt werden, da die differenziell erfasste Messspannung erheblich größer als die über dem Messwiderstand abgenommene gemessene Spannung ist.

In der zweiten Reihenfolge kann diese in einem ungeerdeten Stromversorgungssystem mit mindestens zwei aktiven Leitern derart ausgeführt sein, dass mindestens zwei der aktiven Leiter jeweils separat über einem Messpfad mit dem Erdpotenzial verbunden sind.

Analog zu der Ankopplung mehrerer aktiver Leiter in der ersten Reihenfolge können auch hier völlig separate Messpfade für den jeweiligen aktiven Leiter vorgesehen sein.

In der erfindungsgemäßen Schaltungsanordnung, in denen jeweils ein separater Messpfad in der ersten oder der zweiten Reihenfolge vorliegt, erzeugen die in den jeweiligen Messpfaden angeordneten Messspannungsgeneratoren unterschiedliche Messspannungen, um die Funktionsfähigkeit der Ankopplung zu prüfen.

Dies erlaubt eine Anschlussüberwachung, sodass beispielsweise Leitungsunterbrechungen in den Messpfaden erkannt werden können.

Im operativen Betrieb der Stromversorgungsnetze besteht bei mehrpoliger Ankopplung der Schaltungsanordnung eine niederohmige Verbindung zwischen den Messpfaden über die Quell- und Lastimpedanz des zu überwachenden Stromversorgungssystems. Sind die jeweils treibenden Messspannungen der Messpfade identisch, sollte daher der durch die jeweilige Messspannung getriebene Messstrom in den Ankoppelpfaden ebenfalls identisch sein. Unterscheiden sich die Messspannungen zwischen den Messpfaden, erzeugen diese bei intakter Ankopplung einen Strom über die Quell- und Lastimpedanz. Stimmt dieser Strom nicht mit einem zu erwartenden, aus den vorliegenden Lastkonstellationen und Netzeigenschaften ermittelbarem Stromfluss überein, kann auf diese Weise ein unterbrochener Anschluss des Messpfades erkannt werden.

Die Schaltungsanordnung kann mit mehrpoliger Ankopplung über separate Messpfade zur gleichzeitigen, aktiven Messung eines jeweiligen Isolationswiderstands oder einer komplexwertigen Isolationsimpedanz gegen Erdpotenzial in mehreren ungeerdeten Stromversorgungssystemen verwendet werden, wobei den Messpfaden aktiver Leiter verschiedener Stromversorgungssysteme zugeordnet sind.

In dieser Konfiguration ist eine gleichzeitige Isolationswiderstands- oder Isolationsimpedanzbestimmung für mehrere unabhängige Stromversorgungssysteme mit nur einer mehrpolig ausgeführten Schaltungsanordnung möglich.

Als unabhängige Stromversorgungssysteme sind dabei Netze zu verstehen, die jeweils voneinander isolierte Netzspannungsquellen und eigene Lasten aufweisen.

Da den Messpfaden jeweils ein aktiver Leiter aus verschiedenen Stromversorgungssystemen zugeordnet ist, kann für jedes unabhängige Netz der jeweilige Isolationswiderstand bestimmt werden.

**Bei** der Verwendung der Schaltungsanordnung mit mehrpoliger Ankopplung über separate Messpfade für mehrere unabhängige Stromversorgungssysteme zur Erkennung einer zwischen den Stromversorgungssystemen vorhandenen niederohmigen Verbindung werden die jeweiligen Stromversorgungssysteme mit unterschiedlichen Messspannungen beaufschlagt.

Diese Konfiguration ermöglicht die Isolationswiderstandsbestimmung oder die Isolationsimpedanzbestimmung zwischen zwei unabhängigen Stromversorgungssystemen. Durch Verwendung unterschiedlicher Messspannungen in den Messpfaden stellt sich ein Stromfluss zwischen den Stromversorgungssystemen über die Messpfade ein, sodass eine unbeabsichtigte niederohmige Verbindung ("Crossfault") der Stromversorgungsnetze erkannt und die Elemente dieses "Crossfaults" nach Real- und Imaginärteil bestimmt werden können.

Weitere vorteilhafte Ausgestaltungsmerkmale ergeben sich aus der nachfolgenden Beschreibung und den Zeichnungen, die bevorzugte Ausführungsformen der Erfindung anhand von Beispielen erläutern.

Es zeigen:
- **Fig. 1**: eine Schaltungsanordnung zur Bestimmung eines Isolationswiderstandes nach dem Stand der Technik,
- **Fig. 2**: eine erfindungsgemäße Schaltungsanordnung mit Messpfadelementen in einer ersten Reihenfolge,
- **Fig. 3a**: einen Messpfad mit galvanischer Trennung in einem Differenzverstärker,
- **Fig. 3b**: einen Messpfad mit galvanischer Trennung in der Signalverarbeitung der gemessenen Spannung,
- **Fig. 4**: eine erfindungsgemäße Schaltungsanordnung mit den Messpfadelementen in einer zweiten Reihenfolge,
- **Fig. 5a, 5b**: eine Bestimmung der Messspannung ohne eigene Signalverarbeitung,
- **Fig. 6a, 6b**: einen Messspannungsgenerator mit galvanisch getrennter Versorgung in zwei Ausführungen und
- **Fig. 7**: Anwendung der erfindungsgemäßen Schaltungsanordnung in unabhängigen Stromversorgungssystemen.

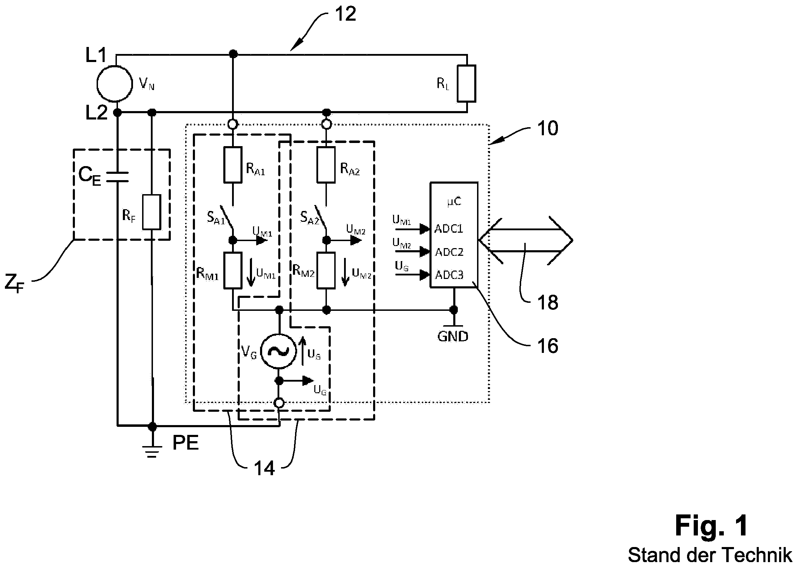

**Fig. 1** zeigt den grundsätzlichen Aufbau einer Schaltungsanordnung 10 zur Bestimmung des Isolationswiderstands (Isolationsüberwachungsgerät) eines ungeerdeten Stromversorgungssystems 12. Eine Netzspannungsquelle V_{N} versorgt über zwei aktive Leiter L1, L2 eine Last R_{L}.

Zwischen die beiden aktiven Leiter L1, L2 und Erde (Erdpotenzial) PE ist das Isolationsüberwachungsgerät 10 geschaltet, welches über einen verzweigten Messpfad 14 jeweils an die aktiven Leiter L1, L2 angekoppelt ist, sodass sich ein geschlossener Messstromkreis über die aktiven Leiter L1, L2 und den Isolationswiderstand R_{F} bilden kann. Das Stromversorgungssystem 12 ist zusätzlich durch eine parallel zu dem Isolationswiderstand R_{F} modellierte Ableitkapazität C_{E} beschrieben, die zusammen mit dem Isolationswiderstand R_{F} eine komplexwertige Isolationsimpedanz Z_{F} bildet. In vereinfachter Darstellung ist diese komplexwertige Isolationsimpedanz Z_{F} nur für den aktiven Leiter L2 dargestellt, grundsätzlich aber ist jeder aktive Leiter L1, L2 mit einer solchen behaftet.

Der Messpfad 14 umfasst ausgehend von dem Erdpotenzial PE einen Messspannungsgenerator V_{G}, einen Messwiderstand R_{M} und einen Ankoppelwiderstand R_{A} (V_{G}, R_{M}, R_{A} und S_{A} sollen hier und im Folgenden stellvertretend für alle jeweils gleichwirkenden Messpfadelemente V_{Gi}, R_{Mi}, R_{Ai} und S_{Ai} bezeichnet werden). Optional ist in jedem Messpfad 14 ein Schalter S_{A} zur Trennung des Isolationsüberwachungsgerätes 10 von dem ungeerdeten Stromversorgungssystem 12 vorgesehen.

Der Messspannungsgenerator V_{G} erzeugt eine Messspannung U_{G}, welche in dem sich über den Isolationswiderstand R_{F} schließenden Messkreis einen Strom treibt, der an dem Messwiderstand R_{M} zu einem messbaren Spannungsabfall (gemessene Spannung) U_{M} führt. Die Messspannung U_{G} sowie die gemessene Spannung U_{M} werden einer Signalauswerteschaltung 16 zugeführt, um den Isolationswiderstand R_{F} zu bestimmen. Die Signalauswerteschaltung 16 weist zur digitalen Signalverarbeitung der Eingangssignale Analog-Digital-Umsetzer ADC und einen Mikrocontroller µC auf sowie eine Schnittstelle 18, beispielsweise zur Ausgabe eines Alarmsignals.

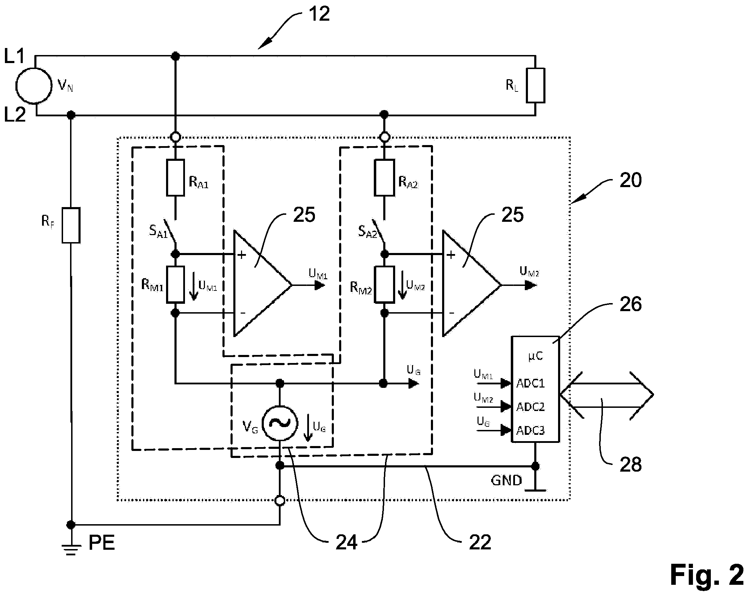

**Fig. 2** zeigt eine erfindungsgemäße Schaltungsanordnung 20, wobei in den verzweigten Messpfaden 24 ausgehend von dem Erdpotenzial PE der Messspannungsgenerator V_{G}, der Messwiderstand R_{M} und der Ankoppelwiderstand R_{A} eine Reihenschaltung in einer ersten Reihenfolge bilden. Erfindungsgemäß ist ein Masseanschluss GND der Signalauswerteschaltung 26 über eine galvanische Verbindung 22 mit dem Erdpotenzial PE verbunden.

Bei Einspeisung eines Wechselstromsignals (Messspannung U_{G}) mittels des Messspannungsgenerators V_{G} kann in der Signalauswerteschaltung 26 über digitale Signalverarbeitungsalgorithmen wie die diskrete Fourier-Transformation (DFT) die komplexwertige Isolationsimpedanz Z_{F} mit ihren Komponenten R_{F} (Realteil) und C_{E} (Imaginärteil) berechnet werden.

In der dargestellten mehrpoligen Ankoppelung verfügen die zwei Messpfade 24 über einen gemeinsamen Messspannungsgenerator V_{G}. Alternativ kann aber auch jeder Messpfad 24 einen eigenen Messspannungsgenerator V_{G} aufweisen.

Bei der Konfiguration in dieser ersten Reihenfolge ist eine hohe Gleichtaktunterdrückung zur Bestimmung der über einen Differenzverstärker 25 (Instrumentenverstärker) erfassten gemessenen Spannung U_{M} erforderlich, da die (kleine) gemessene Spannung U_{M} von einer (großen) Gleichtaktmessspannung U_{G} überlagert wird. Bei den hier vorliegenden Spannungsverhältnissen - die gemessene Spannung U_{M} liegt in der Größenordnung von +-2 Volt gegenüber der Messspannung U_{G}, welche in der Größenordnung von +-20 Volt liegt - wäre ein Instrumentenverstärker mit einer Gleichtaktunterdrückung von mindestens 120 dB zur korrekten Bestimmung der gemessenen Spannung U_{M} erforderlich.

Alternativ zu einem Instrumentenverstärker 25 dieser hohen Güte bietet sich daher an, die erforderliche hohe Gleichtaktunterdrückung durch eine galvanische Trennung in dem Signalverarbeitungspfad für die gemessene Spannung U_{M} zu erreichen.

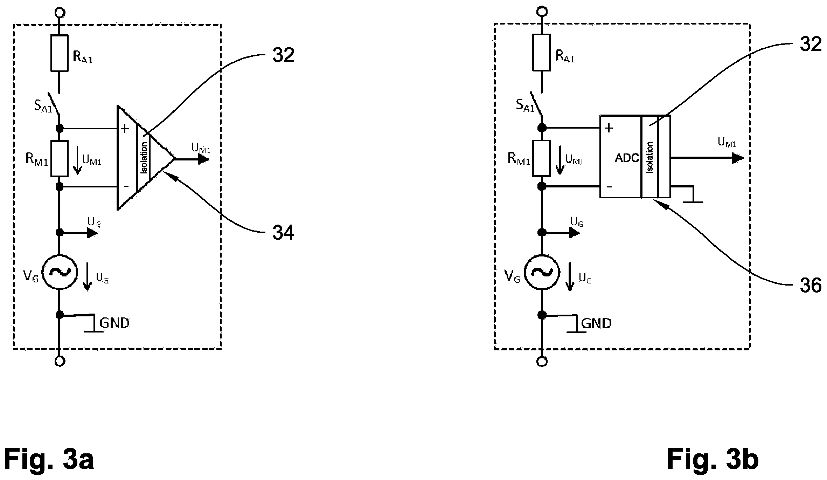

Die **Fig. 3a** und **3b** zeigen hierzu zwei Möglichkeiten. So kann beispielsweise innerhalb der Differenzverstärkerschaltung 34 **(****Fig. 3a****)** oder in der Signalverarbeitung 36 **(****Fig. 3b****)** der gemessenen Spannung U_{M} eine galvanische Trennung 32 vorgesehen sein.

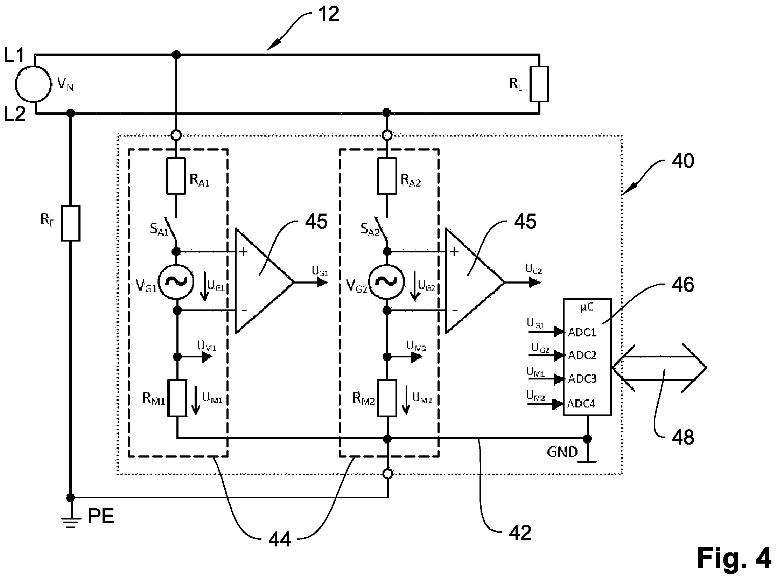

**Fig. 4** zeigt eine erfindungsgemäße Schaltungsanordnung 40 zur Bestimmung des Isolationswiderstandes R_{F} in einem ungeerdeten Stromversorgungssystem 12 mit mehrpoliger Ankopplung. Im Unterschied zu der in Fig. 2 dargestellten ersten Reihenfolge sind in den Messpfaden 44 ausgehend von dem Erdpotenzial PE die Messpfadelemente in einer zweiten Reihenfolge Messwiderstand R_{M}, Messspannungsgenerator V_{G} und Ankoppelwiderstand R_{A} angeordnet. Die gemessenen Spannungen U_{M} werden als Spannungsabfall über dem jeweiligen Messwiderstand R_{M} direkt gegen Erde PE erfasst und zusammen mit den differenziell über einen Differenzverstärker 45 erfassten Messspannungen U_{G} der Signalauswerteeinheit 46 zugeführt.

Erfindungsgemäß ist die Signalauswerteeinheit 46 über eine galvanische Verbindung 42 mit dem Erdpotenzial PE verbunden.

An die Gleichtaktunterdrückung in dem Signalverarbeitungspfad der Messspannung U_{G} können weitaus geringere Anforderungen gestellt werden, da die Messspannung U_{G} erheblich größer als die gemessene Spannung U_{M} ist.

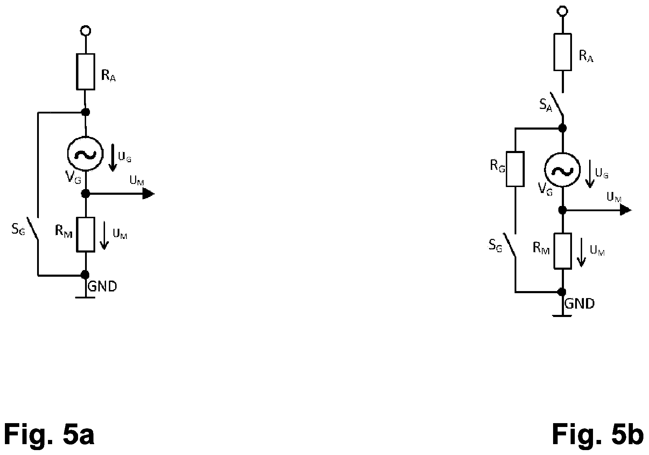

In den **Fig. 5a** und **5b** sind zwei Schaltungsmöglichkeiten zur Bestimmung der Messspannung U_{G} dargestellt. Grundsätzlich wird die Messspannung U_{G} zur Bestimmung des Isolationswiderstandes R_{F} benötigt. Die Messspannung UG muss aber nicht unbedingt bekannt sein, sondern kann durch eine Referenzmessung mit RF = 0 Ohm auf diesen gemessenen Referenzmesswert bezogen werden. Eine zum Abgriff der gemessenen Spannung U_{M} kontinuierliche synchrone Erfassung der Messspannung U_{G} ist nicht erforderlich. So kann Beispielsweise durch Schließen eines parallel zu der Reihenschaltung aus dem Messspannungsgenerator V_{G} und dem Messwiderstand R_{M} angeordneten Schalters S_{G}, wie in **Fig. 5a** dargestellt, die Messspannung U_{G} mittels der Signalauswerteschaltung 26, 46 für die gemessene Spannung U_{M} bestimmt werden.

In Erweiterung der Schaltung aus Fig. 5a kann gemäß **Fig. 5b** der (Trenn-)Schalter S_{A} geöffnet werden und mittels eines zusätzlichen in Reihe zu dem Schalter S_{G} angeordneten Widerstandes R_{G} die gemessene Spannung U_{M} während der Bestimmung von der Messspannung U_{G} an den Pegelbereich der gemessenen Spannung U_{M} angepasst werden.

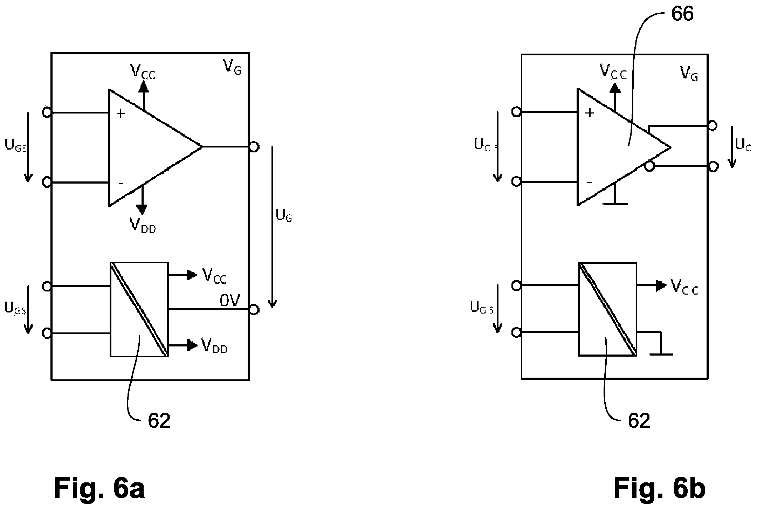

Die **Fig. 6a** und **6b** zeigen einen Messspannungsgenerator V_{G} mit galvanisch getrennter Versorgung. Um messungsverfälschende Querströme über den Messspanungsgenerator V_{G} an dem Messwiderstand R_{M} vorbei gegen den Masseanschluss GND zu vermeiden, muss der Messspannungsgenerator V_{G} eine galvanisch getrennte Versorgung sowie hochohmige Eingänge zur Steuerung aufweisen. Soll die Steuerung des Messspannungsgenerators V_{G} über ein Analogsignal erfolgen und die Messspannung U_{G} bipolar sein, so kann wie in **Fig. 6a** dargestellt, die Messspannungsquelle V_{G} mit einem bipolar über die Spannungen V_{CC} beziehungsweise V_{DD} versorgten Differenzverstärker aufgebaut werden. Dabei versorgt die Versorgungsspannung U_{GS} eine interne, galvanisch getrennte Spannungsquelle 62. Eine Steuerspannung U_{GE} steuert die bipolare Messspannung U_{G}.

Die Komplexität der internen, galvanisch getrennten Spannungsquelle 62 lässt sich durch den Einsatz eines Differenzverstärkers 66 mit Differenzausgang reduzieren. Dieser Verstärkertyp erzeugt, wie in **Fig. 6b** dargestellt, die bipolare Messspannung U_{G} auch bei einer unpolaren Versorgung.

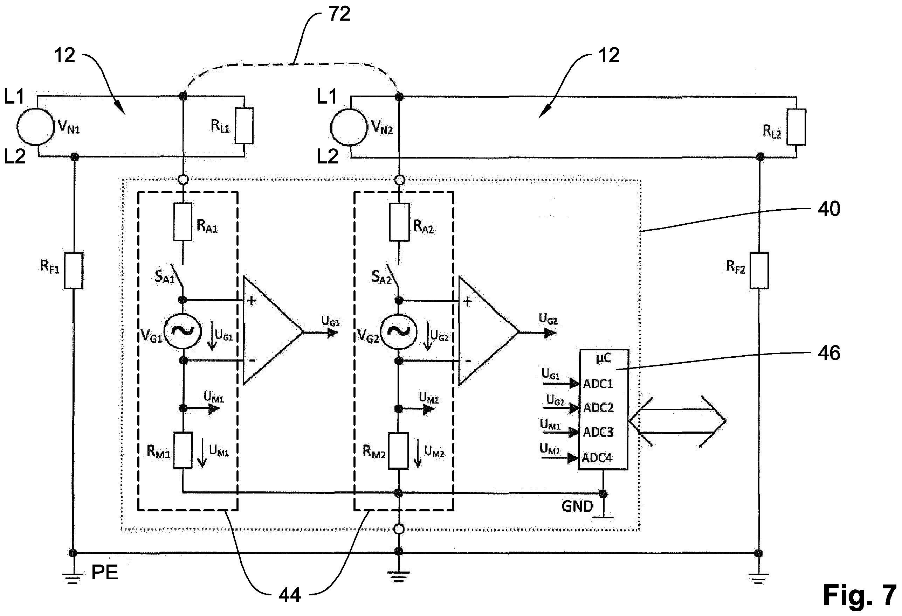

**Fig. 7** zeigt eine Anwendung der erfindungsgemäßen Schaltungsanordnung 40 in der zweiten Reihenfolge nach Fig. 4 in zwei unabhängigen Stromversorgungssystemen 12.

Den zwei Messpfaden 44 ist jeweils ein aktiver Leiter L1 aus den zwei voneinander unabhängigen Stromversorgungssystemen 12 zugeordnet, sodass unabhängig voneinander die jeweiligen Isolationswiderstände R_{F} der Stromversorgungssysteme 12 in der Signalauswerteeinheit 46 bestimmt werden können. Diese Schaltungskonfiguration erlaubt es somit, mit nur einer erfindungsgemäßen Schaltungsanordnung 40 den jeweiligen Isolationswiderstand R_{F} für mehrere unabhängige Stromversorgungssysteme 12 gleichzeitig zu bestimmen, wobei durchaus mehr als die hier exemplarisch dargestellten zwei Stromversorgungssysteme 12 gleichzeitig überwacht werden können. Zudem ist dabei auch eine mehrpolige Ankopplung an das jeweilige Stromversorgungssystem 12 möglich.

Darüber hinaus stellt sich bei unterschiedlicher Größe der Messspannungen U_{G} und einer zwischen den Stromversorgungssystemen 12 vorhandenen niederohmigen Verbindung 72 ("Crossfault") ein Stromfluss ein, der in den Messpfaden 44 detektierbar ist. Ein zwischen den Stromversorgungssystemen 12 auftretender - auch komplexwertiger- "Crossfault" wird somit erkannt.

## Patentansprüche

1. Verwendung einer Schaltungsanordnung mit einer aktiven Messspannung (U_{G}) zur Bestimmung eines Isolationswiderstands (R_{F}) oder einer komplexwertigen Isolationsimpedanz (Z_{F}) eines ungeerdeten Stromversorgungssystems (12) gegen Erdpotenzial (PE), mit einem zwischen einem aktiven Leiter (L1, L2) des Stromversorgungssystems (12) und dem Erdpotenzial (PE) verlaufenden Messpfad (24), der einen Messspannungsgenerator (V_{G}) zur Erzeugung der Messspannung (U_{G}), einen Messwiderstand (R_{M}) zum Abgriff einer gemessenen Spannung (U_{M}) und einen Ankoppelwiderstand (R_{A}) aufweist, und mit einer Signalauswerteschaltung (26), die einen Signaleingang zur Auswertung der gemessenen Spannung (U_{M}) und einen Masseanschluss (GND) aufweist, wobei der Masseanschluss (GND) mit dem Erdpotenzial (PE) verbunden ist,
in dem Messpfad (24) in einer ersten Reihenfolge das Erdpotenzial (PE), der Messspannungsgenerator (V_{G}), der Messwiderstand (R_{M}) und der Ankoppelwiderstand (R_{A}) eine Reihenschaltung bilden, mittels einer mehrpoligen Ankopplung in einem ungeerdeten Stromversorgungssystem (12) mit mindestens zwei aktiven Leitern (L1, L2) mindestens zwei der aktiven Leiter (L1, L2) jeweils über den Messpfad (24) mit dem Erdpotenzial (PE) verbunden sind und die Messpfade (24) separat ausgeführt sind,
**dadurch gekennzeichnet,**
**dass** die jeweiligen Messspannungsgeneratoren (V_{G}) unterschiedliche Messspannungen (U_{G}) erzeugen, um die Funktionsfähigkeit der Ankopplungen zu prüfen.

2. Verwendung einer Schaltungsanordnung (40) mit einer aktiven Messspannung (U_{G}) zur Bestimmung eines Isolationswiderstands (R_{F}) oder einer komplexwertigen Isolationsimpedanz (Z_{F}) eines ungeerdeten Stromversorgungssystems (12) gegen Erdpotenzial (PE), mit einem zwischen einem aktiven Leiter (L1, L2) des Stromversorgungssystems (12) und dem Erdpotenzial (PE) verlaufenden Messpfad (44), der einen Messspannungsgenerator (V_{G}) zur Erzeugung der Messspannung (U_{G}), einen Messwiderstand (R_{M}) zum Abgriff einer gemessenen Spannung (U_{M}) und einen Ankoppelwiderstand (R_{A}) aufweist, und mit einer Signalauswerteschaltung (46), die einen Signaleingang zur Auswertung der gemessenen Spannung (U_{M}) und einen Masseanschluss (GND) aufweist, wobei der Masseanschluss (GND) mit dem Erdpotenzial (PE) verbunden ist,
in dem Messpfad (44) in einer zweiten Reihenfolge das Erdpotenzial (PE), der Messwiderstand (R_{M}), der Messspannungsgenerator (V_{G}) und der Ankoppelwiderstand (R_{A}) eine Reihenschaltung bilden,
mittels einer mehrpoligen Ankopplung in einem ungeerdeten Stromversorgungssystem (12) mit mindestens zwei aktiven Leitern (L1, L2) mindestens zwei der aktiven Leiter (L1, L2) jeweils separat über den Messpfad (44) mit dem Erdpotenzial (PE) verbunden sind,
**dadurch gekennzeichnet,**
**dass** die jeweiligen Messspannungsgeneratoren (V_{G}) unterschiedliche Messspannungen (U_{G}) erzeugen, um die Funktionsfähigkeit der Ankopplungen zu prüfen.

3. Verwendung einer Schaltungsanordnung zur gleichzeitigen, aktiven Messung eines jeweiligen Isolationswiderstands (R_{F}) oder einer komplexwertigen Isolationsimpedanz (Z_{F}) gegen Erdpotenzial (PE) in mehreren ungeerdeten Stromversorgungssystemen (12), wobei Messpfaden (24) aktive Leiter (L1, L2) verschiedener Stromversorgungssysteme (12) zugeordnet sind,
mit einer aktiven Messspannung (U_{G}) zur Bestimmung eines Isolationswiderstands (R_{F}) oder einer komplexwertigen Isolationsimpedanz (Z_{F}) eines ungeerdeten Stromversorgungssystems (12) gegen Erdpotenzial (PE), mit einem zwischen einem aktiven Leiter (L1, L2) des Stromversorgungssystems (12) und dem Erdpotenzial (PE) verlaufenden Messpfad (24), der einen Messspannungsgenerator (V_{G}) zur Erzeugung der Messspannung (U_{G}), einen Messwiderstand (R_{M}) zum Abgriff einer gemessenen Spannung (U_{M}) und einen Ankoppelwiderstand (R_{A}) aufweist, und mit einer Signalauswerteschaltung (26), die einen Signaleingang zur Auswertung der gemessenen Spannung (U_{M}) und einen Masseanschluss (GND) aufweist, wobei
der Masseanschluss (GND) mit dem Erdpotenzial (PE) verbunden ist
in dem Messpfad (24) in einer ersten Reihenfolge das Erdpotenzial (PE), der Messspannungsgenerator (V_{G}), der Messwiderstand (R_{M}) und der Ankoppelwiderstand (R_{A}) eine Reihenschaltung bilden, mittels einer mehrpoligen Ankopplung in einem ungeerdeten Stromversorgungssystem (12) mit mindestens zwei aktiven Leitern (L1, L2) mindestens zwei der aktiven Leiter (L1, L2) jeweils über einen Messpfad (24) mit dem Erdpotenzial (PE) verbunden sind, die Messpfade (24) separat ausgeführt sind,
**dadurch gekennzeichnet,**
**dass** die jeweiligen Stromversorgungssysteme (12) mit unterschiedlichen Messspannungen (U_{G}) beaufschlagt werden zur Erkennung einer zwischen den Stromversorgungssystemen (12) vorhandenen niederimpedanten Verbindung.

4. Verwendung einer Schaltungsanordnung (40) zur gleichzeitigen, aktiven Messung eines jeweiligen Isolationswiderstands (R_{F}) oder einer komplexwertigen Isolationsimpedanz (Z_{F}) gegen Erdpotenzial (PE) in mehreren ungeerdeten Stromversorgungssystemen (12), wobei Messpfaden (44) aktive Leiter (L1, L2) verschiedener Stromversorgungssysteme (12) zugeordnet sind,
mit einer aktiven Messspannung (U_{G}) zur Bestimmung eines Isolationswiderstands (R_{F}) oder einer komplexwertigen Isolationsimpedanz (Z_{F}) eines ungeerdeten Stromversorgungssystems (12) gegen Erdpotenzial (PE), mit einem zwischen einem aktiven Leiter (L1, L2) des Stromversorgungssystems (12) und dem Erdpotenzial (PE) verlaufenden Messpfad (44), der einen Messspannungsgenerator (V_{G}) zur Erzeugung der Messspannung (U_{G}), einen Messwiderstand (R_{M}) zum Abgriff einer gemessenen Spannung (U_{M}) und einen Ankoppelwiderstand (R_{A}) aufweist, und mit einer Signalauswerteschaltung (46), die einen Signaleingang zur Auswertung der gemessenen Spannung (U_{M}) und einen Masseanschluss (GND) aufweist, wobei
der Masseanschluss (GND) mit dem Erdpotenzial (PE) verbunden ist,
in dem Messpfad (44) in einer zweiten Reihenfolge das Erdpotenzial (PE), der Messwiderstand (R_{M}), der Messspannungsgenerator (V_{G}) und der Ankoppelwiderstand (R_{A}) eine Reihenschaltung bilden,
mittels einer mehrpoligen Ankopplung in einem ungeerdeten Stromversorgungssystem (12) mit mindestens zwei aktiven Leitern (L1, L2) mindestens zwei der aktiven Leiter (L1, L2) jeweils separat über einen Messpfad (44) mit dem Erdpotenzial (PE) verbunden sind,
**dadurch gekennzeichnet,**
**dass** die jeweiligen Stromversorgungssysteme (12) mit unterschiedlichen Messspannungen (U_{G}) beaufschlagt werden zur Erkennung einer zwischen den Stromversorgungssystemen (12) vorhandenen niederimpedanten Verbindung.

## Claims

1. A use of a circuit arrangement having an active measuring voltage (U_{G}) for determining an insulation resistance (R_{F}) or a complex-valued insulation impedance (Z_{F}) of an ungrounded power supply system (12) against ground potential (PE), the circuit arrangement having a measuring path (24) which runs between an active conductor (L1, L2) of the power supply system (12) and the ground potential (PE) and comprises a measuring-voltage generator (V_{G}) for generating the measuring voltage (U_{G}), a measuring resistance (R_{M}) for capturing a measured voltage (U_{M}) and a coupling resistance (R_{A}), the circuit arrangement comprising a signal evaluation circuit (26) which comprises a signal input for evaluating the measured voltage (U_{M}) and a ground connection (GND), the ground connection (GND) being connected to the ground potential (PE)
the ground potential (PE), the measuring-voltage generator (V_{G}), the measuring resistance (R_{M}) and the coupling resistance (R_{A}) making up a series connection in the measuring path (24) in a first order, at least two of the active conductors (L1, L2) each being connected to the ground potential (PE) via a measuring path (24) by means of a multi-pole coupling in an ungrounded power supply system (12) having at least two active conductors (L1, L2) and the measuring paths (24) being realized individually,
**characterized in that**
the corresponding measuring-voltage generators (V_{G}) generate different measuring voltages (U_{G}) to test the functionality of the couplings.

2. A use of a circuit arrangement (40) having an active measuring voltage (U_{G}) for determining an insulation resistance (R_{F}) or a complex-valued insulation impedance (Z_{F}) of an ungrounded power supply system (12) against ground potential (PE), the circuit arrangement (40) having a measuring path (44) which runs between an active conductor (L1, L2) of the power supply system (12) and the ground potential (PE) and comprises a measuring-voltage generator (V_{G}) for generating the measuring voltage (U_{G}), a measuring resistance (R_{M}) for capturing a measured voltage (U_{M}) and a coupling resistance (R_{A}), the circuit arrangement (40) comprising a signal evaluation circuit (46) which comprises a signal input for evaluating the measured voltage (U_{M}) and a ground connection (GND), the ground connection (GND) being connected to the ground potential (PE)
the ground potential (PE), the measuring resistance (R_{M}), the measuring-voltage generator (V_{G}) and the coupling resistance (R_{A}) making up a series connection in the measuring path (44) in a second order,
at least two of the active conductors (L1, L2) each being separately connected to the ground potential (PE) via the measuring path (44) by means of a multi-pole coupling in an ungrounded power supply system (12) having at least two active conductors (L1, L2), **characterized in that**
the corresponding measuring-voltage generators (V_{G}) generate different measuring voltages (U_{G}) to test the functionality of the couplings.

3. A use of a circuit arrangement for simultaneous active measuring of a corresponding insulation resistance (R_{F}) or a complex-valued insulation impedance (Z_{F}) against ground potential (PE) in several ungrounded power supply systems (12), active conductors (L1, L2) of different power supply systems (12) being assigned to measuring paths (24),
a circuit arrangement having an active measuring voltage (U_{G}) for determining an insulation resistance (R_{F}) or a complex-valued insulation impedance (Z_{F}) of an ungrounded power supply system (12) against ground potential (PE), the circuit arrangement having a measuring path (24) which runs between an active conductor (L1, L2) of the power supply system (12) and the ground potential (PE) and comprises a measuring-voltage generator (V_{G}) for generating the measuring voltage (U_{G}), a measuring resistance (R_{M}) for capturing a measured voltage (U_{M}) and a coupling resistance (R_{A}), the circuit arrangement comprising a signal evaluation circuit (26) which comprises a signal input for evaluating the measured voltage (U_{M}) and a ground connection (GND), the ground connection (GND) being connected to the ground potential (PE) the ground potential (PE), the measuring-voltage generator (V_{G}), the measuring resistance (R_{M}) and the coupling resistance (R_{A}) making up a series connection in the measuring path (24) in a first order, at least two of the active conductors (L1, L2) each being connected to the ground potential (PE) via a measuring path (24) by means of a multi-pole coupling in an ungrounded power supply system (12) having at least two active conductors (L1, L2), the measuring paths (24) being realized individually,
**characterized in that**
different measuring voltages (U_{G}) are applied to the corresponding power supply systems (12) for identifying a low-impedance connection between the power supply systems (12).

4. A use of a circuit arrangement (40) for simultaneous active measuring of a corresponding insulation resistance (R_{F}) or a complex-valued insulation impedance (Z_{F}) against ground potential (PE) in several ungrounded power supply systems (12), active conductors (L1, L2) of different power supply systems (12) being assigned to measuring paths (24),
a circuit arrangement having an active measuring voltage (U_{G}) for determining an insulation resistance (R_{F}) or a complex-valued insulation impedance (Z_{F}) of an ungrounded power supply system (12) against ground potential (PE), the circuit arrangement having a measuring path (44) which runs between an active conductor (L1, L2) of the power supply system (12) and the ground potential (PE) and comprises a measuring-voltage generator (V_{G}) for generating the measuring voltage (U_{G}), a measuring resistance (R_{M}) for capturing a measured voltage (U_{M}) and a coupling resistance (R_{A}), and the circuit arrangement comprising a signal evaluation circuit (46) which comprises a signal input for evaluating the measured voltage (U_{M}) and a ground connection (GND), the ground connection (GND) being connected to the ground potential (PE),
the ground potential (PE), the measuring resistance (R_{M}), the measuring-voltage generator (V_{G}) and the coupling resistance (R_{A}) making up a series connection in the measuring path (44) in a second order,
at least two of the active conductors (L1, L2) each being separately connected to the ground potential (PE) via a measuring path (44) by means of a multi-pole coupling in an ungrounded power supply system (12) having at least two active conductors (L1, L2), **characterized in that**
different measuring voltages (U_{G}) are applied to the corresponding power supply systems (12) for identifying a low-impedance connection between the power supply systems (12).

## Revendications

1. Utilisation d'un arrangement de circuit ayant une tension de mesure (U_{G}) active pour la détermination d'une résistance d'isolement (R_{F}) ou d'une impédance d'isolement (Z_{F}) en valeur complexe d'un système d'alimentation électrique (12) non mis à la terre au potentiel de terre (PE), l'arrangement de circuit ayant une voie de mesure (24) qui s'étend entre un conducteur actif (L1, L2) du système d'alimentation électrique (12) et le potentiel de terre (PE) et qui comprend un générateur tension de mesure (V_{G}) pour la génération de la tension de mesure (U_{G}), une résistance de mesure (R_{M}) pour la prise d'une tension mesurée (U_{M}) et une résistance de couplage (R_{A}), l'arrangement de circuit comprenant un circuit (26) d'évaluation de signal qui comprend une entrée de signal pour l'évaluation de la tension mesurée (U_{M}) et une connexion de terre (GND), la connexion de terre (GND) étant reliée à un potentiel de terre (PE)
le potentiel de terre (PE), le générateur tension de mesure (V_{G}), la résistance de mesure (R_{M}) et la résistance de couplage (R_{A}) formant un montage en série dans la voie de mesure (24) dans un premier ordre, au moins deux des conducteurs actifs (L1, L2) chacun étant relié au potentiel de terre (PE) par la voie de mesure (24) au moyen d'un couplage multipolaire dans un système d'alimentation électrique (12) non mis à la terre ayant au moins deux conducteurs actifs (L1, L2) et les voies de mesure (24) étant réalisées individuellement,
**caractérisé en ce que**
les générateurs tension de mesure (V_{G}) correspondants génèrent des tensions de mesure (U_{G}) différentes afin d'essayer le fonctionnement de couplages.

2. Utilisation d'un arrangement de circuit (40) ayant une tension de mesure (U_{G}) active pour la détermination d'une résistance d'isolement (R_{F}) ou d'une impédance d'isolement (Z_{F}) en valeur complexe d'un système d'alimentation électrique (12) non mis à la terre au potentiel de terre (PE), l'arrangement de circuit (40) ayant une voie de mesure (44) qui s'étend entre un conducteur actif (L1, L2) du système d'alimentation électrique (12) et le potentiel de terre (PE) et qui comprend un générateur tension de mesure (V_{G}) pour la génération de la tension de mesure (U_{G}), une résistance de mesure (R_{M}) pour la prise d'une tension mesurée (U_{M}) et une résistance de couplage (R_{A}), l'arrangement de circuit (40) comprenant un circuit (46) d'évaluation de signal qui comprend une entrée de signal pour l'évaluation de la tension mesurée (U_{M}) et une connexion de terre (GND), la connexion de terre (GND) étant reliée à un potentiel de terre (PE)
le potentiel de terre (PE), la résistance de mesure (R_{M}), le générateur tension de mesure (V_{G}) et la résistance de couplage (R_{A}) formant un montage en série dans la voie de mesure (44) dans un deuxième ordre,
au moins deux des conducteurs actifs (L1, L2) chacun étant relié individuellement au potentiel de terre (PE) par une voie de mesure (44) au moyen d'un couplage multipolaire dans un système d'alimentation électrique (12) non mis à la terre ayant au moins deux conducteurs actifs (L1, L2),
**caractérisé en ce que**
les générateurs tension de mesure (V_{G}) correspondants génèrent des tensions de mesure (U_{G}) différentes afin d'essayer le fonctionnement de couplages.

3. Utilisation d'un arrangement de circuit pour la mesure active simultanée d'une résistance d'isolement (R_{F}) correspondante ou d'une impédance d'isolement (Z_{F}) en valeur complexe au potentiel de terre (PE) dans plusieurs systèmes d'alimentation électriques (12) non mis à la terre, des conducteur actifs (L1, L2) des systèmes d'alimentation électriques (12) différentes étant associés à des voies de mesure (24),
l'arrangement de circuit ayant une tension de mesure (U_{G}) active pour la détermination d'une résistance d'isolement (R_{F}) ou d'une impédance d'isolement (Z_{F}) en valeur complexe d'un système d'alimentation électrique (12) non mis à la terre au potentiel de terre (PE), l'arrangement de circuit ayant une voie de mesure (24) qui s'étend entre un conducteur actif (L1, L2) du système d'alimentation électrique (12) et le potentiel de terre (PE) et qui comprend un générateur tension de mesure (V_{G}) pour la génération de la tension de mesure (U_{G}), une résistance de mesure (R_{M}) pour la prise d'une tension mesurée (U_{M}) et une résistance de couplage (R_{A}), l'arrangement de circuit comprenant un circuit (26) d'évaluation de signal qui comprend une entrée de signal pour l'évaluation de la tension mesurée (U_{M}) et une connexion de terre (GND), la connexion de terre (GND) étant reliée à un potentiel de terre (PE)
le potentiel de terre (PE), le générateur tension de mesure (V_{G}), la résistance de mesure (R_{M}) et la résistance de couplage (R_{A}) formant un montage en série dans la voie de mesure (24) dans un premier ordre,
au moins deux des conducteurs actifs (L1, L2) chacun étant relié au potentiel de terre (PE) par une voie de mesure (24) au moyen d'un couplage multipolaire dans un système d'alimentation électrique (12) non mis à la terre ayant au moins deux conducteurs actifs (L1, L2), les voies de mesure (24) étant réalisées individuellement,
**caractérisé en ce que**
les systèmes d'alimentation électriques (12) correspondants sont soumis à des tensions de mesures (U_{G}) différentes pour l'identification d'une connexion à basse impédance entre les systèmes d'alimentation électriques (12).

4. Utilisation d'un arrangement de circuit (40) pour la mesure active simultanée d'une résistance d'isolement (R_{F}) correspondante ou d'une impédance d'isolement (Z_{F}) en valeur complexe au potentiel de terre (PE) dans plusieurs systèmes d'alimentation électriques (12) non mis à la terre, des conducteur actifs (L1, L2) des systèmes d'alimentation électriques (12) différentes étant associés à des voies de mesure (24),
l'arrangement de circuit (40) ayant une tension de mesure (U_{G}) active pour la détermination d'une résistance d'isolement (R_{F}) ou d'une impédance d'isolement (Z_{F}) en valeur complexe d'un système d'alimentation électrique (12) non mis à la terre au potentiel de terre (PE), l'arrangement de circuit (40) ayant une voie de mesure (44) qui s'étend entre un conducteur actif (L1, L2) du système d'alimentation électrique (12) et le potentiel de terre (PE) et qui comprend un générateur tension de mesure (V_{G}) pour la génération de la tension de mesure (U_{G}), une résistance de mesure (R_{M}) pour la prise d'une tension mesurée (U_{M}) et une résistance de couplage (R_{A}), l'arrangement de circuit (40) comprenant un circuit (46) d'évaluation de signal qui comprend une entrée de signal pour l'évaluation de la tension mesurée (U_{M}) et une connexion de terre (GND), la connexion de terre (GND) étant reliée au potentiel de terre (PE)
le potentiel de terre (PE), la résistance de mesure (R_{M}), le générateur tension de mesure (V_{G}) et la résistance de couplage (R_{A}) formant un montage en série dans la voie de mesure (44) dans un deuxième ordre,
au moins deux des conducteurs actifs (L1, L2) chacun étant relié individuellement au potentiel de terre (PE) par une voie de mesure (44) au moyen d'un couplage multipolaire dans un système d'alimentation électrique (12) non mis à la terre ayant au moins deux conducteurs actifs (L1, L2),
**caractérisé en ce que**
les systèmes d'alimentation électriques (12) correspondants sont soumis à des tensions de mesures (U_{G}) différentes pour l'identification d'une connexion à basse impédance entre les systèmes d'alimentation électriques (12).
